# EUROPEAN PATENT APPLICATION

(11) **EP 4 575 471 A1**
(43) Date of publication of application: **25.06.2025**
(21) Application number: 23307249.5
(22) Date of filing: 18.12.2023
(51) Int. Cl.: G01N 21/88, G01B 11/30, G01N 21/95, H01L 21/67, H01L 21/66, H01L 21/00, G01N 21/84

(54) **A DEVICE AND A METHOD FOR DETECTING CRYSTALLINE DEFECTS IN A SUBSTRATE BY DARK FIELD**

(71) Applicant: UNITY SEMICONDUCTOR, 38330 Montbonnot-Saint-Martin (FR)
(72) Inventor: VERGNET, Hadrien, 38400 Saint-Martin-d'Hères (FR)
(74) Representative: IPAZ

(57) **Abstract**

The invention relates to a device (100) for detecting crystalline defects in an off-axis monocrystalline substrate (10), wherein the normal to the surface of the substrate (10) is tilted with respect to the crystallographic growth axis by a tilt angle, the tilt angle being contained in a plane, called angle plane, perpendicular to the surface of the substrate, the device (100) comprising:
- a detector (14),
- at least one illumination light source (12) configured to illuminate the substrate (10) with an illuminating light beam (13), said at least one illumination light source (12) being arranged in at least one of a first position and a second position,
- imaging means (16) configured to image the substrate (10) according to a field of view on the detector (14), said detector (14) producing at least one image of the substrate (10), and
- processing means (18) configured to detect crystalline defects using said at least one image of the substrate,

wherein the at least one illumination light source (12) and the imaging means (16) are arranged in a dark-field configuration, and
wherein in the first position, the at least one illumination light source (12) is arranged such that the illuminating light beam is parallel or quasi-parallel to the angle plane, and in the second position, the at least one illumination light source (12) is arranged such that the illuminating light beam is parallel or quasi-parallel to a plane, called perpendicular plane, containing the normal to the surface of the substrate and being perpendicular to the angle plane.

The invention also relates to a method for detecting crystalline defects in an off-axis monocrystalline substrate.

## Description

### Field of the invention

The present invention relates to a device for detecting crystalline defects in monocrystalline substrates, such as silicon carbide substrates. It also relates to a method implemented by such a device.

The field of the invention is the field of inspection and characterization of semiconductor substrates by optical methods.

### Background

Monocrystalline substrates or wafers for electronics, optics, or optoelectronics applications, need to be inspected to detect, identify, and/or characterize possible crystalline defects present on their surface or below their surface. Crystalline defects are defects resulting from the fact that the atoms arrange locally in an unexpected way during the growth of the crystal. This can result in subsequent defects or causes of failure in the components, such as transistors or diodes, fabricated with these substrates.

Such substrates include notably silicon carbide (SiC), which is grown as a monocrystalline boule, and then usually sliced in wafers according to a specific orientation with respect to the crystalline axis, usually referred to as "off axis", and possibly provided with additional monocrystalline layer(s) added on top by an epitaxial process. Such wafers are in particular used to manufacture power components, for instance for the automotive industry or other power-related applications. Other materials such as silicon (Si) can also be provided as monocrystalline off-axis substrates or wafers.

The crystalline defects can be very detrimental to the performance and the reliability of these components. It is therefore important to detect such defects at an early stage.

Several measurement techniques are known to detect and classify crystalline defects, such as dark-field detection, photoluminescence detection, or combinations of these techniques.

Dark-field detection allows revealing the defects present at the surface of a substrate. This technique is based on an illumination of the surface and the collection of the scattered light. The illumination is arranged with an angle of incidence such that the specular reflection is not collected.

Dark-field detection systems are quite simple and efficient. However, they are not specific or selective enough to allow for detecting and classifying crystalline defects. It is for instance difficult to distinguish with such technique crystalline defects from other defects, such as particles contaminating the surface of the substrate, or scratches or pits due to external causes non-related to the crystalline growth.

### Summary of the invention

A purpose of the present invention is to overcome at least one of the drawbacks of the known techniques.

A purpose of the present invention is to provide a device and a method for the detection of crystalline defects in off-axis, monocrystalline substrates, such as silicon carbide substrates, or silicon substrates.

It is also a purpose of the invention to improve the discrimination of crystalline effects with respect to other non-crystalline defects.

It is another purpose of the invention to provide a device and a method for the detection of crystalline defects in off-axis, monocrystalline substrates, allowing a high throughput and minimizing the measurement time.

At least one of these aims is achieved by a device for detecting crystalline defects in an off-axis monocrystalline substrate, wherein the normal to the surface of the substrate is tilted with respect to the crystallographic growth axis by a tilt angle, the tilt angle being contained in a plane, called angle plane, perpendicular to the surface of the substrate, the device comprising:
- a detector,
- at least one illumination light source configured to illuminate the substrate with an illuminating light beam, said at least one illumination light source being arranged in at least one of a first position and a second position,
- imaging means configured to image the substrate according to a field of view on the detector, said detector producing at least one image of the substrate, and
- processing means configured to detect crystalline defects using said at least one image of the substrate,

wherein the at least one illumination light source and the imaging means are arranged in a dark-field configuration, and
wherein in the first position, the at least one illumination light source is arranged such that the illuminating light beam is parallel or quasi-parallel to the angle plane, and in the second position, the at least one illumination light source is arranged such that the illuminating light beam is parallel or quasi-parallel to a plane, called perpendicular plane, containing the normal to the surface of the substrate and being perpendicular to the angle plane.

The imaging means may comprise for instance optical lenses or an objective. The processing means may comprise a computer, a microprocessor or a controller and the necessary hardware such as I/O boards and frame grabber to acquire and process images from the detector.

The detection device according to the present invention allows for an improved detection of crystalline defects in off-axis monocrystalline substrates.

In the device according to the invention, the illumination light beam is oriented in specific directions relative to the crystallographic growth axis, namely parallel or quasi-parallel to the angle plane, and/or parallel or quasi-parallel to a perpendicular plane containing the normal to the surface of the substrate and being perpendicular to the angle plane, respectively.

These two illumination arrangements and orientation allow for detecting almost any kind of crystalline defect. Indeed, most of the crystalline defects develop with the crystal growth, and generate patterns which extend mostly along the crystalline axis directions, in the direction parallel to the plane formed by the crystallographic axis and the normal to the wafer surface, or in the direction parallel to the perpendicular plane containing the normal to the surface of the substrate and being perpendicular to the angle plane.

According to the invention, the illumination is also arranged parallel or quasi-parallel to at least one of these directions, in order to generate a strong response in terms of scattered light from defects extending substantially perpendicularly to the direction of illumination. For other illumination arrangements and orientations, as it has been observed, crystalline defects trigger very little, or at least much less response. On the other hand, non-crystalline defects don't have in the general case any privileged orientation and may trigger a more uniform response regardless of the orientation of the illumination. The discrimination of crystalline defects from other defects is thus improved.

In a dark-field configuration as used in the invention, the specular reflection of the light on or in the substrate is not collected on the detector. Only the light scattered or diffracted by the substrate is collected. As the illumination is made in specific angular orientations, the arrangement of the device according to the present invention may also be referred to as directional dark-field arrangement.

The dark-field configuration of the device according to the invention allows for primarily revealing surface defects that scatter the illumination light. If the illumination light penetrates the substrate, it may also be scattered by defects below the surface of the substrate.

So, if the area of interest is on or close to the surface of the substrate, the illumination light wavelength may be chosen to have a limited depth of penetration into the substrate.

An off-axis substrate is a substrate, for instance a wafer, with a tilt angle, or off-angle, corresponding to the angle between the growth or stacking direction and the normal of the surface of the substrate, different from zero.

The tilt angle is introduced to ensure high-quality homoepitaxial growth on the surface of the substrate, such as a wafer, when growing additional layers on it. Additional epitaxial layers may be used to introduce various dopants, and/or to ensure layers with less crystalline defects than the substrate.

A substrate, as referred to herein, may comprise a bulk monocrystalline substrate, or a bulk monocrystalline substrate with one or several additional layers grown on it by epitaxy.

Examples of off-axis monocrystalline materials include silicon (Si) or silicon carbide (SiC), with for instance 6H-SiC and 4H-SiC polytypes.

According to an embodiment, in the first position, the at least one illumination light source is arranged such that the illuminating light beam is parallel to a plane containing the normal to the surface of the substrate and forming an angle smaller than +/- 10°, preferably smaller than +/- 5°, more preferably smaller than +/- 4°, with the angle plane.

The direction of the illuminating light beam may correspond for instance to an optical axis of the light emitted by the light source. The illumination light source is then arranged so that the direction of illumination is within a small angle from the plane formed by the normal to the substrate's surface and the crystallographic axis in the growth direction. In other words, the illuminating light beam is then parallel or quasi-parallel to the angle plane. Being quasi-parallel means that it deviates from the angle plane of a small angle, corresponding to +/- 10°, or +/- 5°, or +/- 4°.

In the second position, the at least one illumination light source may be arranged such that the illuminating light beam is parallel to a plane containing the normal to the surface of the substrate and forming an angle smaller than +/- 10°, preferably smaller than +/- 5°, more preferably smaller than +/- 4°, with the perpendicular plane.

The direction of the illuminating light beam may correspond for instance to an optical axis of the light emitted by the light source. The illumination light source is then arranged so that the direction of illumination is within a small angle from the perpendicular plane, i.e., the plane perpendicular to the plane containing the illumination direction of the first light source. In other word, the illuminating light beam is then parallel or quasi-parallel to the perpendicular plane. Being quasi-parallel means for instance that it deviates from the perpendicular plane of a small angle, such as +/- 10°, or +/- 5°, or +/- 4°.

The device of the invention may comprise an illumination light source arranged sequentially in the first position and the second position.

According to some other embodiments, the device according to the invention may comprise a first illumination light source arranged in the first position and a second illumination light source arranged in the second position.

The combined use of a light source in the first and the second position can reveal most of the crystalline defects.

Advantageously, the device according to the invention may comprise an illumination light source arranged in a third position different from the first and second positions and configured to illuminate the substrate with a supplemental illuminating light beam.

That supplemental illuminating light beam may be provided by an illumination light source arranged sequentially in at least one of the first and the second position, and in the third position. Alternatively, the supplemental illuminating light beam may be provided by a supplemental illumination light source arranged in the third position.

The acquisition of images of the substrate illuminated with at least one illumination light source arranged in the first and/or second position, and with a light source arranged in a third position different from the first and/or second position, respectively, allows for a better discrimination of crystalline defects relative to other, non-crystalline defects. Indeed, the illumination from this third position triggers a very low response from the crystalline defects while the other, non-crystalline, defects have response to illumination which is much less sensitive to the orientation of the illumination. By comparing images acquired with an illumination in the first and/or second position, and with an illumination in the third position, respectively, a discrimination or a rejection of the non-crystalline defects can be conveniently realized.

The discrimination of the crystalline with respect to the other non-crystalline defects is thus improved.

Non-crystalline defects comprise, for example, particles contaminating the surface of the substrate, or scratches or pits due to external causes non-related to the crystalline growth (abrasion, etc.).

It is to be noted that without an illumination light source arranged in the third position, the defects as detected by the invention can be of crystalline or non-crystalline origin. However, thanks to the invention, crystalline defects provide a particularly strong response among other defects which improve their detection. In addition, by contrast with non-crystalline defects, many crystalline defects have a response to illumination which is very different for an illumination in the first and the second position, respectively. So, by comparing the information obtained with the illumination light source arranged in the first and the second position, many crystalline defects can be identified and discriminated from non-crystalline defects. But of course, an illumination in a third position improves the discrimination between crystalline and non-crystalline defects.

In the third position, the illumination light source may be arranged such that the supplemental illuminating light beam is parallel to a plane containing the normal to the surface of the substrate and forming an angle larger than +/- 5°, preferably larger than +/- 10° with the angle plane and with the perpendicular plane, respectively.

The device may be arranged to provide one or a plurality of supplemental illuminating light beam(s) having one or a plurality of orientations with respect to the angle plane and the perpendicular plane, respectively, each being parallel to a plane containing the normal to the surface of the substrate and forming an angle larger than +/- 5° (or larger than 5° in absolute value), preferably larger than +/- 10° (or larger than 10° in absolute value) with the angle plane and with the perpendicular plane, respectively.

The at least one illumination light source may be arranged such that a direction of the illuminating light beam is within an angle of 20° - 89°, or preferably 30°-85°, or even more preferably 55°-80°, to the normal of the surface of the substrate.

These directions of illumination are chosen to ensure that the dark field condition is fulfilled. Furthermore, using illumination with large incidence angles with respect to the normal to the surface improve the selectivity of the detection of the crystalline defects, which is provided in the invention by the illumination positioned in specific angular positions, previously defined as the first and the second position. That selectivity is provided by the fact that the crystalline defects have a strong response to the illumination only for an illuminating beam whose angular orientation is in a narrow angular range around the angle plane and the perpendicular plane. Because of the scattering patterns generated by the defects, it can be shown that that selectivity increases with the angle of incidence of the illuminating beam with respect to the normal to the surface of the substrate. For instance, with a collimated illuminating beam (having only one angular direction of incidence), it can be shown that the angle of incidence of the illuminating beam with respect to the normal to the surface shall be larger than 30° to provide that crystalline defects have a significant response only for angles of incidence within 10° of the angle plane or the perpendicular plane, and larger than 55° to have a significant response only within +/-4° of these planes.

According to another aspect of the invention, it is proposed a method for detecting crystalline defects in an off-axis monocrystalline substrate, wherein the normal to the surface of the substrate is tilted with respect to the crystallographic growth axis by a tilt angle, the tilt angle being contained in a plane, called angle plane, perpendicular to the surface of the substrate, the method being implemented with a device comprising a detector, at least one illumination light source, imaging means, and processing means, the at least one illumination light source and the imaging means being arranged in a dark-field configuration, the method comprising:
- illuminating, with the at least one illumination light source, the substrate with an illuminating light beam, the at least one illumination light source being arranged in at least one of a first position and a second position;
- imaging, with the imaging means, the substrate according to a field of view on the detector;
- producing with said detector at least one image of the substrate; and
- detecting, with the processing means, crystalline defects using said at least one image of the substrate;
wherein in the first position, the at least one illumination light source is arranged such that the illuminating light beam is parallel or quasi-parallel to the angle plane, and in the second position, the at least one illumination light source is arranged such that the illuminating light beam is parallel or quasi-parallel to a plane, called perpendicular plane, containing the normal to the surface of the substrate and being perpendicular to the angle plane.

According to an embodiment, the method may comprise at least one of the following steps:
- illuminating the substrate with an illumination light source arranged in the first position, and producing an image of the substrate;
- illuminating the substrate with an illumination light source arranged in the second position, and producing an image of the substrate;
- simultaneously illuminating the substrate with a first and a second illumination light source respectively arranged in the first and the second position, and producing an image of the substrate.

Thus, a separate image may be acquired when using illumination light source(s) in the first and the second position, respectively.

Separate acquisitions allow for a better discrimination of the different types of crystalline defects.

Alternatively, an image may be acquired when using both first and second illumination light sources in the first and the second position simultaneously.

According to an embodiment, the method according to the invention may further comprise:
- illuminating the substrate with a illumination light source arranged in a third position different from the first and second positions, and
- producing a supplemental image of the substrate.

The method may further comprise discriminating crystalline defects from non-crystalline defects by comparing defects detected in said supplemental image and defects detected in at least one image obtained with at least one illumination light source arranged in at least one of the first and the second position.

In that case, two or three images can be acquired sequentially, with respectively illumination light source(s) in the first and/or the second position, and in the third position.

The acquired images may be compared to discriminate the crystalline defects, which are mostly present on the images acquired with the illumination light source(s) in the first and/or the second position, while the other, non-crystalline defects are present on all images.

Alternatively, the comparison can be realized by comparing defects identified separately on the respective images.

### Description of the figures and embodiments

Other advantages and characteristics will become apparent on examination of the detailed description of an embodiment which is in no way limitative, and the attached figures, where:
- FIGURE 1 shows an example of a crystalline wafer of 4H-SiC with the different axes and the tilt angle referred to in the present document,
- FIGURE 2 is a diagrammatic representation of a detection device according to a non-limitative embodiment of the present invention,
- FIGURE 3a, 3b, 3c illustrate respectively an illumination configuration in the detection device according to a non-limitative embodiment of the present invention,
- FIGURE 4 illustrates a method for detecting crystalline defects in substrates according to a non-limitative embodiment of the present invention,
- FIGURES 5a, 5b illustrate examples of measurements realized according to the present invention on a 4H-SiC wafer with an epitaxial layer, with an illumination light source in the first position,
- FIGURES 6a, 6b illustrate a comparative example of measurements realized according to the present invention on a 4H-SiC wafer with an epitaxial layer, with an illumination light source in the first position and the second position, respectively,
- FIGURE 7a and 7b illustrate another comparative examples of measurements realized according to the present invention on a 4H-SiC wafer with an epitaxial layer, with an illumination light source in the first position and the second position, respectively,
- FIGURE 8 illustrates the variation of contrast of a crystalline defect in function of an angle of illumination.

It is well understood that the embodiments that will be described below are in no way limitative. In particular, it is possible to imagine variants of the invention comprising only a selection of the characteristics described hereinafter, in isolation from the other characteristics described, if this selection of characteristics is sufficient to confer a technical advantage or to differentiate the invention with respect to the state of the prior art. Such a selection comprises at least one, preferably functional, characteristic without structural details, or with only a part of the structural details if this part alone is sufficient to confer a technical advantage or to differentiate the invention with respect to the prior art.

In the following FIGURES, elements common to several figures may keep the same reference sign.

The embodiments described below relate to devices and methods for detecting crystalline defects in off-axis monocrystalline substrates. As previously mentioned, such substrates present a tilt angle, or off-angle, larger than zero between the crystallographic growth direction and the normal to the surface of the substrate.

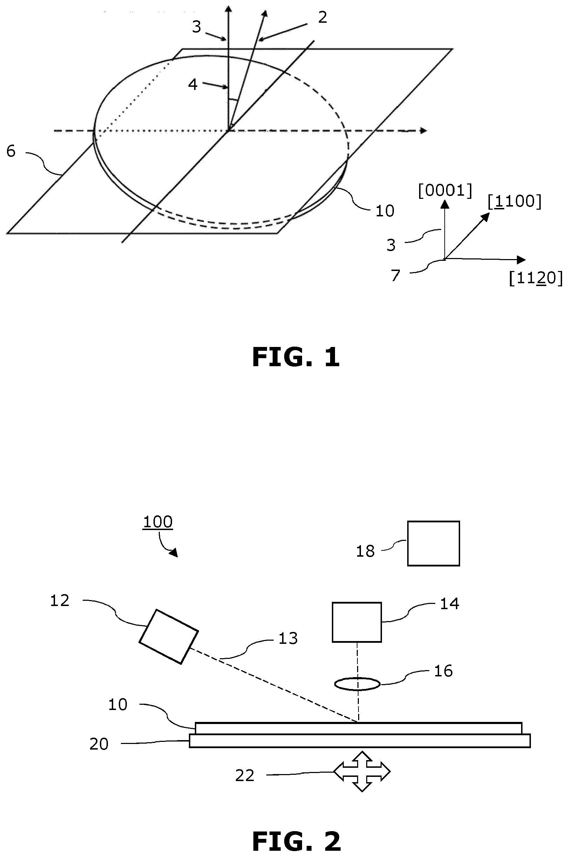

FIGURE 1 illustrates a monocrystalline off-axis wafer 10 of silicon carbide (SiC), of 4H-SiC polytype, with the different crystallographic directions or axes 7 and the tilt angle 4 referred to herein. The wafer 10 is made from a SiC boule grown on the [0001] face 6, corresponding to the crystallographic [0001] C-axis 3 according to the Miller Indices notation. As described for instance in the SEMI M55-0921 standard, the wafer 10 is then extracted, for instance by slicing, from the SiC boule with an orientation such that the normal 2 to its surface forms with the crystallographic C-axis 3 a tilt angle 4, also called off-angle 4. According to the SEMI M55-0921 standard, the normal 2 is tilted, with respect to the [0001] axis 3, toward the [1120] direction. The off-axis angle is typically 4° toward the [1120] axis.

The plane containing the tilt angle is called angle plane, or tilt angle plane, in the present document. In the example illustrated in FIGURE 1, the angle plane is the plane containing the [0001] and [1120] axes. It contains also the normal 2 to the surface.

Typically, crystalline defects in such monocrystalline wafers, with or without epitaxial layer, develop in the direction of growth, or at least in directions related to the direction of growth. They result in dislocations or discontinuities of the crystalline structure extending mostly in directions corresponding to orientations of crystalline axes. In the case of a 4H-SiC off-axis wafer as illustrated in FIGURE 1, these defects extend mostly along the [0001], [1120] and [1100] axes.

A defect present in the substrate, such as a basal plane dislocation (BPD), a threading edge dislocation (TED), or a threading screw dislocation (TSD), may be converted into a different type of defect when crossing the interface between the substrate and an epitaxial layer, but the orientation of the defect both before and after the conversion stays related to the direction of the crystal growth.

FIGURE 2 is a diagrammatic representation of a non-limitative example of a detection device according to the present invention.

The device 100, represented in FIGURE 2, may be used to detect crystalline and non-crystalline defects in semiconductor substrates, such as SiC or Si wafers with or without additional epitaxial layer(s).

The device 100 is based on an optical dark-field detection scheme.

The device 100 comprises an illumination light source 12 for a substrate 10 with an illumination light beam 13. More than one illumination light source may be used to illuminate the substrate 10.

The device 100 also comprises a detector 14. The detector 14 may comprise, for example, a matrix camera such as a CCD or CMOS camera. Of course, other types of detectors can be used, such as line or point detectors associated with a scanning system.

The device 100 comprises imaging means or an optical imaging arrangement 16 configured to image the substrate 10, or a part of it, according to a field of view, on the detector 14. The imaging means 16 may comprise one or more imaging lenses, such as an objective lens, or an objective and a detector lens or a tube lens, and other optical components such as filters, or apertures.

The imaged field of view may cover the full surface of the substrate 10 or a part of it. In the latter case, the field of view may be positioned at different locations over the surface of the substrate, for instance to obtain an image of the whole substrate by stitching a plurality of fields of view.

The detector 14 then produces an image of the substrate 10, for example of its surface or of any other plane within the substrate 10.

The device 100 also comprises processing means 18 for processing the acquired images, and in particular for detecting crystalline defects from the images.

The processing means 18 may comprise, in a non-limitative way, a computer, a microprocessor, a controller board, and all the hardware necessary, such as volatile and non-memory memory, analogic to digital converters, and I/O boards, to perform crystalline defects detection and identification according to the invention.

The device 100 further comprise a wafer chuck 20 to hold the substrate 10. It also comprises positioning means 22 such as translation and/or rotary stages to position the substrate, in translation and/or in rotation, relative to the imaging means.

The illumination light source(s) 12 and the imaging means 16 are disposed in a dark-field configuration, which means that the specular reflection of the light issued from the illumination light source 12 on or in the substrate 10 is not collected by the imaging mean 16 and does not reach the detector 14. Only the light scattered or diffracted by the substrate is collected and reach the detector 14.

Preferably, the illumination light wavelength is chosen to have a limited depth of penetration into the substrate to provide a more localized information. For instance, the wavelength may be chosen to be:
- a wavelength corresponding to an energy smaller than the bandgap of the substrate material, for example 310 nm for 4H-SiC;
- a wavelength which is well absorbed by a dopant present in the material, for example 460 nm for n-type 4H-SiC or 620 nm for n-type 6H-SiC. Such wavelengths are also easier to detect by common cameras.

According to the invention, the illumination light source(s) 12 are placed or arranged in very specific angular positions with respect to the substrate 10.

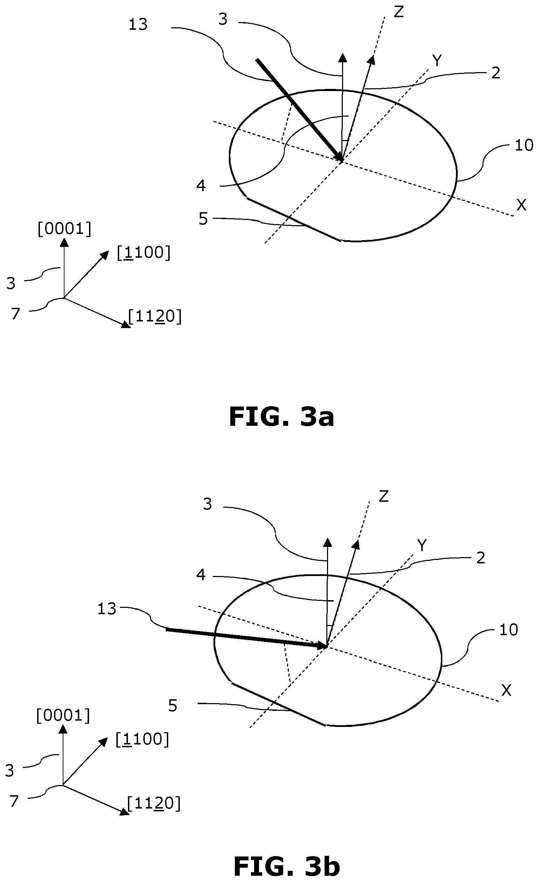

FIGURE 3a illustrates the illumination configuration for an illumination light source 12 positioned in a first position.

In the first position, the illuminating light beam 13 from the light source is set parallel (for instance within +/-4°) to the angle plane, i.e., the plane containing the normal 2 to the wafer surface and the crystallographic axis 3 in the growth direction, and thus the tilt angle 4 formed by the normal 2 to the wafer surface and the crystallographic axis 3 in the growth direction.

As illustrated in FIGURE 3a, using a reference system with axis X, Y, Z as illustrated, the surface of the substrate 10 is contained in an X-Y plane. The normal 2 to the wafer surface is oriented along a Z direction and the crystallographic axis 3 in the growth direction is contained in the X-Z plane. The direction of illumination is thus also contained in the X-Z plane.

As an example, in the case of a SiC wafer, and more particularly a 4H-SiC wafer, the crystallographic axis in the growth direction 3 corresponds to the C-axis [0001]. The direction of illumination for the first position is then parallel or quasi-parallel to the plane containing the normal 2 to the wafer surface and the [1120] crystallographic axis.

As already explained, wafers for the manufacturing of electronic components are fabricated according to well-established standards and their crystalline axis have also well-defined orientations with respect to positioning flats or notches. For example, according to some configurations widely used in the industry, a 4H-SiC wafer manufactured according to the SEMI M55-0921 standard has an orientation flat 5 parallel to the [1120] axis, as illustrated in FIGURE 3a. In that case, the direction of illumination in the first position shall be in a plane parallel or quasi-parallel to that flat 5.

Thanks to these standardized configurations, the positioning of the light source in the first position may thus be realized easily, for instance by positioning angularly the wafer in the correct orientation on the chuck 20 using a pre-positioner and the flat 5, or by using positioning means 22 with a rotary stage. Alternatively, or in addition, the light source can be angularly positioned with respect to the wafer.

The illumination from the illumination light source in the first position allows for detecting mostly crystalline defects that extend, for 4H-SiC, in the growth direction [0001] of the substrate and along the [1100] axis.

FIGURE 3b illustrates the illumination configuration for an illumination light source 12 positioned in a second position.

In the second position, the illumination light beam 13 from the illumination light source is set parallel (for instance within +/-4°) to the perpendicular plane, i.e. the plane containing the normal 2 to the surface of the substrate and being perpendicular to the angle plane.

The illumination direction of the light source in the second position, or at least its projection in the X-Y plane, is thus perpendicular or quasi-perpendicular to the illumination direction of the light source in the first position, or at least its projection in the X-Y plane. It is contained in the Y-Z plane.

As an example, in the case of a 4H-SiC wafer, the direction of illumination for the second position is then parallel or quasi-parallel to the plane containing the normal 2 to the wafer surface and the [1100] crystallographic axis.

The illumination from the illumination light source in the second position allows for detecting mostly crystalline defects that extend, for 4H-SiC, in the growth direction [0001] of the substrate and along the [1120] axis.

According to some embodiments, the device 100 may have one illumination light source 12 arranged in one of a first position and a second position, to measure from one of these positions only.

According to some embodiments, the device 100 may have also a same illumination light source 12 arranged to be used sequentially in the first and the second position. In that case, the wafer can be rotated, for instance using a rotary stage of the positioning means 22, or an external wafer positioner. The illumination light source 12 can also be placed on a rotating element allowing to position it in the first and the second position, respectively.

According to some other embodiments, the device 100 may comprise two illumination light sources. One of the light sources is then arranged in the first position and the other light source is arranged in the second position. The light sources may then illuminate the substrate simultaneously or alternatively.

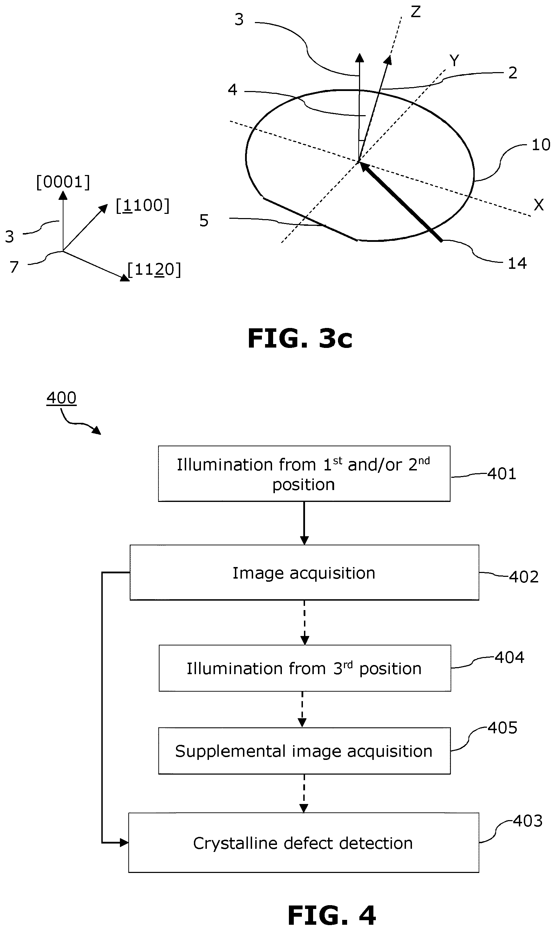

In an embodiment illustrated in FIGURE 3c, the device according to the invention further comprises an illumination light source 12 arranged in a third position different from the first and second positions. That illumination light source is configured to illuminate the substrate with a supplemental illuminating light beam 14.

That third position corresponds to a position of the illumination light source such that the supplemental illuminating light beam 14 is parallel to a plane containing the normal to the surface and whose angular orientation in the X-Y plane is different from the angle plane and the perpendicular plane defined previously. In particular, the supplemental illuminating light beam may be parallel to a plane forming an angle larger than +/- 10°, with the angle plane and with the perpendicular plane, respectively.

As previously, the supplemental illuminating light beam may be generated with a same illumination light source as for the first and for the second position, by positioning angularly the light source in various positions. Alternatively, a supplemental light source may be specifically positioned at the third position. In both embodiments, a single or a plurality of third positions may be used.

The illumination with the supplemental illuminating light beam allows for imaging and detecting non-crystalline defects and discriminate them from crystalline defects. Indeed, as the orientation of the illumination in the third position is significantly different from the orientation of the crystalline axis, the crystalline defects generate weaker responses in the images acquired with that configuration. So, while crystalline defects may only or mostly be detected from images acquired with the illumination in the first and/or the second position, non-crystalline defects are present in images acquired with illumination in any of the first, second, or third position.

In the embodiments illustrated in FIGURE 3a, 3b, and 3c, to ensure a proper angular selectivity of the response of the crystalline defects, the angular orientation of the illuminating beam relative to the Z axis, i.e., the normal of the substrate's surface, is set at 55°.

The device according to the embodiment represented in FIGURE 2 may be implemented in order to detect crystalline defects in substrates. The device may in particular be implemented in a method for detecting crystalline defects according to the invention.

FIGURE 4 illustrates a method for detecting crystalline defects in substrates according to an embodiment of the present invention.

The method 400 comprises an illumination step 401 from the first and/or the second position. A substrate is illuminated using an illumination light source positioned in the first position or in the second position.

The first and second positions correspond to the positions as previously described with reference to the device of the invention. In the first position, an illuminating light beam from the light source is contained in a plane being parallel or quasi-parallel to the tilt angle plane as previously defined, and in the second position, an illumination light beam from the illumination light source is contained in a plane containing the normal to the surface of the substrate and being perpendicular or quasi-perpendicular to the tilt angle plane.

Alternatively, in the illumination step 401, the substrate can be illuminated using two illumination light sources, of which the first one is positioned in the first position and the second one is positioned in the second position. In this case, the substrate can be illuminated simultaneously, or sequentially, by the first and the second illumination light sources.

The substrate can also be illuminated sequentially by an illumination light source positioned sequentially in the first and the second position.

In an image acquisition step 402, one or several images of the substrate 10 are acquired, according to a field of view. The substrate 10 is imaged on a detector using the imaging means 16, such as an objective lens or an objective and a detector lens. One or more images are then produced on the detector, according to the field of view of the imaging means.

In the image acquisition step 402, an image may be acquired for each illumination configuration as described in step 401.

In particular, an image is acquired when the substrate is illuminated with an illumination light source arranged in the first or the second position, respectively.

Similarly, an image is acquired when the substrate is illuminated simultaneously by illumination light sources arranged respectively in the first and the second position.

Alternatively, two or more images are acquired sequentially when the substrate is illuminated sequentially by illumination light source(s) in the first and the second position.

The method 400 according to the invention further comprises a detection step 403. Crystalline defects are detected by processing the acquired images of the substrate.

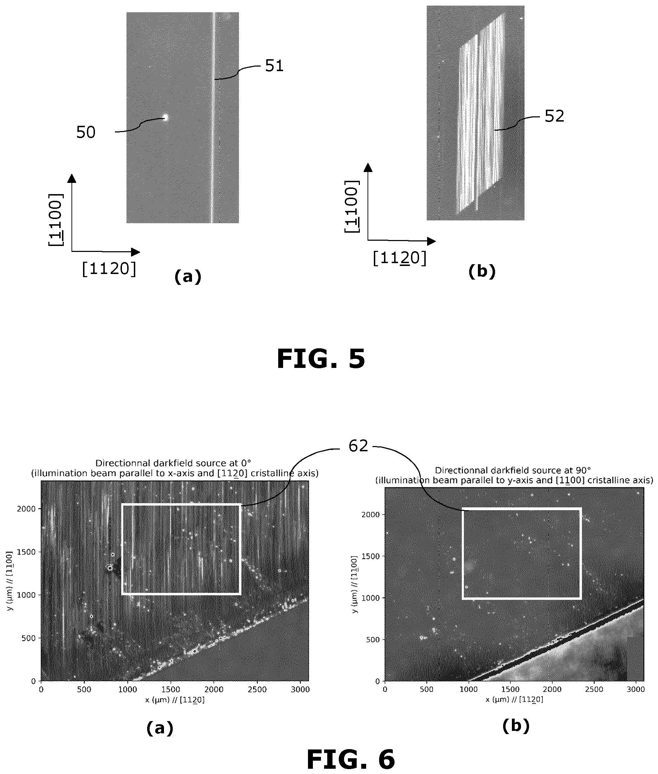

As illustrated on FIGURE 5 to FIGURE 8, crystalline defects appear as contrasted patterns on a background, having for many of them characteristic shapes. So, the detection step 403 may comprise any known technique for image processing and classification, such as thresholding, segmentation, pattern detection, blob analysis, ....

FIGURE 5 illustrates examples of crystalline defects detected with a device and method according to the present invention on a 4H-SiC wafer with an epitaxial layer. In these examples, the substrate 10 is illuminated with an illumination light source in the first position.

FIGURE 5(a) shows a "micropipe" 50, or TSD, already present in the base substrate layer and an associated stacking fault 51, resulting from the presence of the TSD, in the epitaxial layer.

FIGURE 5(b) shows a step-bunching defect 52. Such defect may appear in the epitaxial layer when grown on a base substrate with a surface quality issue. It is due to an uneven formation of crystalline planes in presence of the tilt angle.

FIGURE 6 illustrates another example of crystalline defect detection in a 4H-SiC substrate.

FIGURE 6(a) shows a measurement of a step bunching obtained with an illuminating beam parallel to the [1120] crystalline axis, i.e., with an illumination light source being in the first position.

FIGURE 6(b) shows the same measurement with the illumination in the perpendicular direction, i.e., with an illuminating beam perpendicular to the [1120] axis. The illumination light source is then in the second position. As it can be observed, notably in the area 62, the contrast of the step bunching defects practically drops to zero for this illumination direction. It can also be observed that other types of detects, such as non-crystalline defects, are visible with the two directions of illumination.

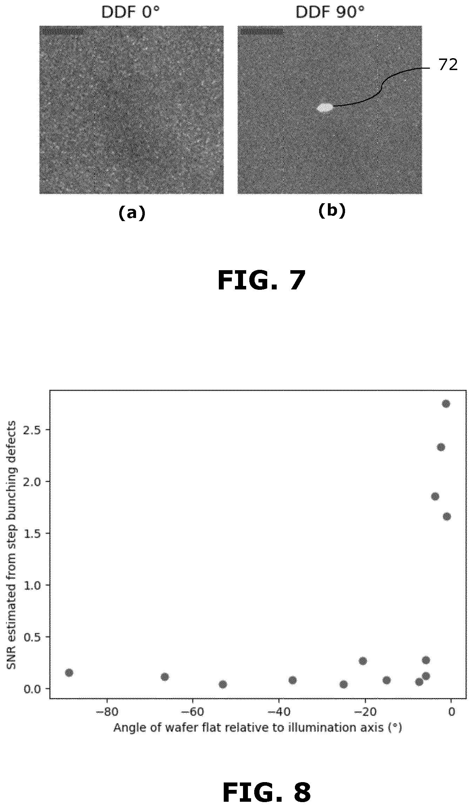

FIGURE 7 shows another example of crystalline defect detection in a 4H-SiC substrate.

In FIGURE 7(a), the illumination light source is positioned in the first position, i.e., the illumination beam is in the angle plane and parallel to the [1120] axis. No crystalline defect is visible.

In FIGURE 7(b), the illumination light source is positioned in the second position, i.e., the illumination beam is in the perpendicular plane and perpendicular to the [1120] axis. It reveals a carrot defect 72.

By comparing FIGURE 6 and FIGURE 7, it appears that some crystalline defects are visible only with an illumination in the first position, while other are visible only with an illumination in the second position. So, by using these two positions of illumination, it is possible to detect and classify efficiently these defects. It is also possible to discriminate non crystalline defects, which shall appear in a more similar way with both position of illumination, as shown for instance in FIGURE 6(a) and 6(b).

FIGURE 8 shows the effect of the directional illumination on the detection of a step-bunching defect. The signal-to-noise ratio (SNR), i.e., the contrast of the step-bunching defect with respect to the surrounding 4H-SiC substrate, is shown as a function of the orientation in the X-Y plane of the illumination beam. 0° corresponds to the plane containing the [1120] crystalline axis, i.e., with the illumination light source being in the first position.

It appears that the contrast is optimal for a direction of illumination contained in the plane with the [1120] axis, and falls quickly for a direction of illumination deviating from that orientation. As shown on the graph, the contrast is above null or noise level for angles smaller than 10 degrees (in absolute value), and better for angles smaller than 5 degrees.

The method 400 according to the embodiment as represented in FIGURE 4 may further comprise an optional supplemental illumination step 404. In this step 404, the substrate is illuminated with an illumination light source positioned in a least one third position.

That or these third position(s) correspond(s) to the position(s) as described previously with reference to the device of the invention. In a third position, the substrate is illuminated with a supplemental illuminating light beam is contained in a plane between the angle plane and the perpendicular plane.

Then, in a supplemental image acquisition step 405, a supplemental image of the substrate, illuminated by a light source at a third position, is acquired. Several images may be acquired for several respective third positions.

That or these supplemental images are then used in the crystalline defect detection step 403. Crystalline defects are discriminated from non-crystalline defects by comparing defects detected in the supplemental image(s) and defects detected in image(s) acquired with the illumination light source arranged in the first and/or in the second position.

For example, the non-crystalline defects are can better be detected in the supplemental images. In these images indeed, most of the crystalline defects have a very low contrast. Then the images obtained with the illumination in the first and/or second position are processed. These images contain crystalline defects and non-crystalline defects. By using the information from the supplemental images, the non-crystalline defects are identified and removed to retain only the crystalline defects or separated to classify the defects in crystalline and non-crystalline categories.

Of course, several implementations are possible. The defects can be segmented and identified in all images before being categorized and analysed.

Alternatively, non-crystalline defect signatures can be located in the supplemental images, for instance by analysing local intensity variations, and these locations can be removed from the later detection steps when processing the images acquired with the illumination light source arranged in the first and/or in the second position to detect crystalline defects.

It is also possible to combine, for instance by subtraction, the images, to remove the content of the supplemental images from the content of the images with the crystalline defects.

Of course, non-crystalline defects can be identified and rejected to retain crystalline defects, or crystalline defects can be identified and rejected to retain non-crystalline defects, or both type of defects can be separated and processed.

Of course, the invention is not limited to the examples detailed above.

## Claims

1. A device (100) for detecting crystalline defects in an off-axis monocrystalline substrate (10), wherein the normal (2) to the surface of the substrate (10) is tilted with respect to the crystallographic growth axis (3) by a tilt angle (4), the tilt angle (4) being contained in a plane, called angle plane, perpendicular to the surface of the substrate (10), the device (100) comprising:
- a detector (14),
- at least one illumination light source (12) configured to illuminate the substrate (10) with an illuminating light beam (13), said at least one illumination light source (12) being arranged in at least one of a first position and a second position,
- imaging means (16) configured to image the substrate (10) according to a field of view on the detector (14), said detector (14) producing at least one image of the substrate (10), and
- processing means (18) configured to detect crystalline defects using said at least one image of the substrate (10),
wherein the at least one illumination light source (12) and the imaging means (16) are arranged in a dark-field configuration, and
wherein in the first position, the at least one illumination light source (12) is arranged such that the illuminating light beam (13) is parallel or quasi-parallel to the angle plane, and in the second position, the at least one illumination light source (12) is arranged such that the illuminating light beam (13) is parallel or quasi-parallel to a plane, called perpendicular plane, containing the normal (2) to the surface of the substrate (10) and being perpendicular to the angle plane.

2. The device (100) according to claim 1, wherein in the first position, the at least one illumination light source (12) is arranged such that the illuminating light beam (13) is parallel to a plane containing the normal (2) to the surface of the substrate (10) and forming an angle smaller than +/- 10°, preferably smaller than +/- 5°, more preferably smaller than +/- 4° with the angle plane.

3. The device (100) according to claim 1 or 2, wherein in the second position, the at least one illumination light source (12) is arranged such that the illuminating light beam (13) is parallel to a plane containing the normal (2) to the surface of the substrate (10) and forming an angle smaller than +/- 10°, preferably smaller than +/- 5°, more preferably smaller than +/- 4° with the perpendicular plane.

4. The device (100) according to any one of the preceding claims, which comprises a first illumination light source arranged in the first position and a second illumination light source arranged in the second position.

5. The device (100) according to any of the preceding claims, which further comprises an illumination light source (12) arranged in a third position different from the first and second positions and configured to illuminate the substrate (10) with a supplemental illuminating light beam.

6. The device (100) according to claim 5, wherein in the third position, the illumination light source (12) is arranged such that the illuminating light beam is parallel to a plane containing the normal (2) to the surface of the substrate (10) and forming an angle larger than +/- 5°, preferably larger than +/- 10° with the angle plane and with the perpendicular plane, respectively.

7. The device (100) according to any one of the preceding claims, wherein the at least one illumination light source (12) is arranged such that a direction of the illuminating light beam (13) is within an angle of 20° - 89°, or preferably 30°-85°, or even more preferably 55°-80°, to the normal (2) of the surface of the substrate (10).

8. A method (400) for detecting crystalline defects in an off-axis monocrystalline substrate (10), wherein the normal (2) to the surface of the substrate (10) is tilted with respect to the crystallographic growth axis (3) by a tilt angle (4), the tilt angle (4) being contained in a plane, called angle plane, perpendicular to the surface of the substrate (10), the method being implemented with a device (100) comprising a detector (14), at least one illumination light source (12), imaging means (16), and processing means (18), the at least one illumination light source (12) and the imaging means (16) being arranged in a dark-field configuration, the method (400) comprising:
- illuminating (401), with the at least one illumination light source (12), the substrate (10) with an illuminating light beam (13), the at least one illumination light source (12) being arranged in at least one of a first position and a second position;
- imaging, with the imaging means (16), the substrate (10) according to a field of view on the detector (14);
- producing (402) with said detector (14) at least one image of the substrate (10); and
- detecting (403), with the processing means (18), crystalline defects using said at least one image of the substrate (10);
wherein in the first position, the at least one illumination light source (12) is arranged such that the illuminating light beam (13) is parallel or quasi-parallel to the angle plane, and in the second position, the at least one illumination light source (12) is arranged such that the illuminating light beam (13) is parallel or quasi-parallel to a plane, called perpendicular plane, containing the normal (2) to the surface of the substrate (10) and being perpendicular to the angle plane.

9. The method (400) according to claim 8, which comprises at least one of the following steps:
- illuminating the substrate (10) with an illumination light source arranged in the first position, and producing an image of the substrate (10);
- illuminating the substrate (10) with an illumination light source arranged in the second position, and producing an image of the substrate (10);
- simultaneously illuminating the substrate (10) with a first and a second illumination light source respectively arranged in the first and the second position, and producing an image of the substrate (10).

10. The method (400) according to claim 8 or 9, which further comprises:
- illuminating (404) the substrate (10) with an illumination light source (12) arranged in a third position different from the first and second positions, and
- producing (405) a supplemental image of the substrate (10).

11. The method (400) according to claim 10, which further comprises discriminating (406) crystalline defects from non-crystalline defects by comparing defects detected in said supplemental image and defects detected in at least one image obtained with at least one illumination light source (12) arranged in at least one of the first and the second position.
